# FASCICULE DE BREVET EUROPEEN

(11) **EP 1 894 647 B1**
(45) Date de publication et mention de la délivrance du brevet: **19.10.2011**
(21) Numéro de dépôt: 07115186.4
(22) Date de dépôt: 29.08.2007
(51) Int. Cl.: B22C 7/02, B22C 9/04, B22D 27/04, C30B 11/00, C30B 11/14, C30B 29/52

(54) **Procédé de fabrication de germes monocristallins simultanément à la coulée de pièces monocristallines**
Verfahren zur gleichzeitigen Herstellung von monokristallinen Keimen beim Gießen von monokristallinen Teilen
Method of producing monocrystalline seeds simultaneously when casting monocrystalline parts

(30) Priorité: 29.08.2006 FR 0653510
(43) Date de publication de la demande: 05.03.2008
(73) Titulaire: SNECMA, 75015 Paris (FR)
(72) Inventeur: Aprile, Umberto, 92500 Rueil Malmaison (FR); Giral, Jean- Claude, 95600 Eaubonne (FR); Lallement, Bernard, 95600 Eaubonne (FR); Verger, Jean- Louis, 93140 Bondy (FR)
(74) Mandataire: David, Daniel

(56) Documents cités:
- EP-A1- 0 087 379
- FR-A1- 2 724 857
- US-A- 4 714 101

## Description

La présente invention concerne le domaine de la fabrication de pièces ayant une orientation cristallographique dirigée, notamment de pièces monocristallines, par solidification dirigée d'un alliage de structure cristallographique cubique dans un moule carapace. Plus particulièrement la solidification est menée à partir d'un germe starter.

La solidification dirigée consiste à alimenter un moule en métal fondu et à faire progresser le front de solidification le long d'un axe de croissance selon une orientation cristallographique déterminée. Dans les superalliages de nickel par exemple, l'orientation <001> prédomine. Cependant il existe aussi des modes de solidification qui permettent d'orienter également la solidification par rapport à un plan perpendiculaire à l'axe de solidification primaire. L'orientation cristallographique mesurée le long de l'axe principal d'une pièce moulée est appelée orientation primaire et l'orientation polaire dans un plan perpendiculaire à l'axe principal est appelée orientation transverse ou secondaire.

L'invention s'applique aux pièces monocristallines pour lesquelles il est nécessaire de respecter une orientation cristalline primaire <001>.

L'invention s'applique plus particulièrement aux pièces monocristallines pour lesquelles il s'agit de respecter deux orientations cristallines : une orientation cristalline primaire <001> et une orientation transverse <010> par rapport à l'axe de la solidification.

Lorsqu'il s'agit de ne respecter que l'orientation primaire <001>, on utilise un germe starter monocristallin, sans indexation en rotation, ou bien un sélecteur en chicane ou en queue de cochon. C'est le cas pour la fabrication d'aubes mobiles HP où la pale est parallèle à l'axe de solidification. Un procédé de fabrication selon cette technique est décrit dans le brevet FR 2734188 au nom de la demanderesse.

Si on souhaite que les deux orientations cristallines - primaire et secondaire - soient respectées, on utilise un germe starter comportant une indexation en rotation. C'est le cas par exemple pour une pièce telle qu'un distributeur monocristallin, fabriqué selon le procédé décrit dans le brevet FR2724857 au nom de la demanderesse, pour lequel la pale est transverse par rapport à l'axe de solidification.

Dans le cas de la fabrication de distributeurs haute pression désignés DHP : pour respecter les deux orientations cristallines, le germe starter est indexé en rotation lors du montage cire au moyen d'un outillage de positionnement ou bien l'ensemble du modèle cire comportant le germe starter - l'amenée de grain, le modèle cire DHP et le germe brut sont injectés monoblocs dans un moule.

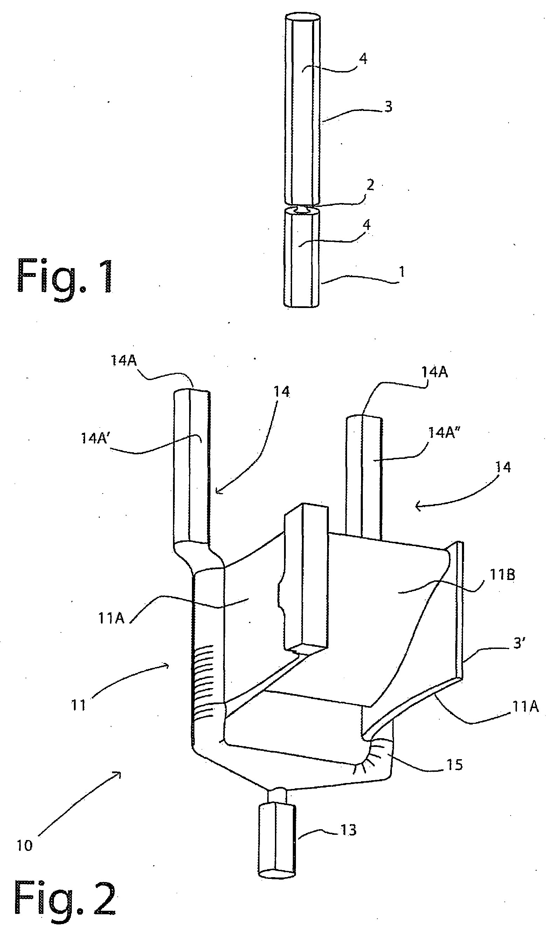

De manière habituelle, les germes monocristallins utilisés dans la fabrication de distributeurs monocristallins pour moteurs civils et militaires sont également fabriqués par le procédé de fonderie à cire perdue. Les différentes étapes de fabrication consistent tout d'abord à fabriquer une grappe en cire comprenant, comme cela est représenté sur la figure 1, un germe starter 1, un diaphragme 2 et un barreau 3 ayant la forme cylindrique des germes que l'on souhaite obtenir. On prévoit généralement de former les germes avec un méplat 4 pour en permettre l'orientation dans le moule carapace de la pièce et assurer l'orientation cristallographique des dendrites de la pièce à obtenir.

Le mode de fabrication des germes est donc le suivant. On fabrique autour du modèle en cire comportant le germe, le diaphragme et le barreau, une carapace céramique. Cette carapace est obtenue par des opérations alternées de trempé dans une barbotine céramique suivi de l'application de couches de sable par immersion dans un lit fluidisé ou saupoudrage pluie. Après chaque trempé et application de sable céramique, on effectue un séchage intercouche. On répète plusieurs fois cet enchaînement d'opérations jusqu'à obtenir l'épaisseur voulue pour le moule carapace. On procède ensuite à son séchage final.

L'étape suivante consiste à éliminer la cire du moule carapace et à en effectuer la cuisson. Il est alors prêt pour la coulée de l'alliage. Un germe monocristallin est placé dans un logement cylindrique prévu à cet effet dans la base de la carapace céramique puis celle-ci est disposée dans l'enceinte d'un four classique pour solidification dirigée. Le métal est coulé dans le moule et vient remplir le vide laissé par le décirage. L'alliage vient en contact avec le germe qui refond partiellement. On procède à la solidification par tirage. On obtient en fin de tirage un barreau monocristallin. La carapace est ensuite décochée ; les barreaux sont découpés aux dimensions requises et contrôlés afin de vérifier les orientations primaires et secondaires des germes obtenus. Ces germes sont disponibles comme germes starter pour la fabrication de pièces monocristallines, par exemple des distributeurs.

Cette fabrication spécifique constitue une phase supplémentaire dans la réalisation de pièces monocristallines déjà complexe en soi.

La demande de brevet européenne EP 0087379 décrit un procédé de fabrication d'un germe brut lors de la réalisation d'une pièce monocristalline, qui sera utilisé lors de la fabrication d'une autre pièce monocristalline.

L'invention a pour objet de simplifier la fabrication des germes dans le but de réduire globalement le coût d'obtention de pièces monocristallines.

Conformément à l'invention on parvient à réaliser cet objectif par le procédé suivant de fabrication de deux germes monocristallins susceptiblesd'être utilisés comme germe starter dans la fabrication d'un distributeur haute pression de turbomachine, avec au moins une pale entre deux plateformes, monocristallin, par coulée de métal. Ce procédé est caractérisé par le fait que
- on réalise un modèle en cire comprenant un premier élément formant modèle du distributeur, un deuxième élément formant modèle de germe starter comportant un méplat de localisation des orientations cristallines et deux troisièmes éléments incorporant un modèle de germe brut avec un méplat de localisation des orientations cristallines,
- on forme un moule carapace en céramique à partir dudit modèle en cire et on incorpore un germe starter comportant ledit méplat de localisation des orientations cristallines dans le moule,
- on coule un métal dans le moule et on opère une solidification dirigée du métal dans le moule à partir du germe starter de manière que les germes bruts obtenus ait la même structure cristallographique que la pièce et on sépare les germes bruts obtenus de la pièce pour une utilisation ultérieure comme germe starter.

L'invention permet ainsi de fabriquer des germes à partir de la grappe avec laquelle on fabrique une ou plusieurs pièces monocristallines nécessitant le respect en fabrication série des orientations cristallographiques primaire et secondaire. Il n'est donc plus nécessaire de fabriquer les germes séparément à l'aide d'un moule carapace spécifique. Le nombre de germes obtenus à partir d'une telle pièce peut être par exemple de deux dans le cas de la fabrication d'un distributeur monocristallin. Les distributeurs étant fabriqués en série, on atteint facilement le nombre de germes suffisant pour fabriquer d'autres distributeurs. Ceci engendre une réduction de coût appréciable.

De préférence, pour un modèle comprenant au moins un élément pour l'amenée de coulée métal, le modèle de germe brut est incorporé dans ledit élément pour l'amenée de coulée de métal formant ledit troisième élément.

Le procédé permet ainsi un contrôle radiocristallographique de la pièce effectué à partir du germe brut. Pendant que l'on contrôle l'orientation cristallographique du germe brut, les opérations de parachèvement de la pièce monocristalline peuvent être effectuées en parallèle. On réalise donc des gains de cycle de fabrication de la pièce. Par ailleurs en utilisant une ou les amenées de coulée comme germes bruts on permet d'effectuer le contrôle des orientations cristallographiques d'une pièce monocristalline simplement en contrôlant le germe brut obtenu dans l'amenée de la coulée.

L'invention s'applique notamment à un modèle comprenant un élément formant amenée de grain entre l'élément formant germe starter et le premier élément formant modèle de pièce.

Conformément à une caractéristique, la pièce est orientée de façon que les pales soient disposées selon l'axe secondaire de solidification et les plateformes selon l'axe primaire de solidification. Plus particulièrement, le modèle comprend deux éléments formant amenées de coulée de métal en fusion, chacun incorporant un élément formant genne brut.

Selon un premier mode de réalisation le modèle est formé par injection monobloc dans un moule à cire ménageant l'ensemble desdits éléments.

Selon un autre mode de réalisation, le modèle est forme par injection dans un moule à cire ménageant les premier et deuxième éléments, le troisième élément formant germe brut étant réalisé séparément puis rapporté sur le modèle. Plus particulièrement dans ce cas un moyen d'indexation est ménagé entre le troisième élément et le modèle.

Notamment le moyen d'indexation est constitué par une liaison de type tenon et mortaise entre le modèle et l'élément formant modèle de genne brut.

Globalement les avantages sont :
La réduction des coûts d'obtention des gennes bruts qui serviront ensuite de germes starter,
Le contrôle de l'orientation cristalline des pièces réalisé par un simple contrôle de l'orientation cristalline du germe brut. Il est ainsi possible d'effectuer le parachèvement des pièces en parallèle avec le contrôle des germes bruts. Cei permet une réduction du cycle de fabrication de la pièce et par conséquent un gain de coût.

Brève description des figures :
La figure 1 représente en perspective, un assemblage de l'art antérieur pour obtenir des germes monocristallins à partir d'un barreau,
La figure 2 montre un modèle en cire de distributeur monocristallin conforme à l'invention avec deux éléments de modèle formant germes bruts avant confection du moule carapace à partir du modèle,
La figure 3 représente un modèle en cire de distributeur monocristallin selon une variante de l'invention où les germes bruts sont assemblés par collage sur le distributeur,
La figure 4 représente un modèle en cire de distributeur monocristallin selon une autre variante de l'invention où les germes bruts sont assemblés par collage sur le distributeur avec indexation grâce à un assemblage tenon mortaise.

### Description détaillée

Parmi les pièces monocristallines dont la géométrie nécessite une orientation transverse par rapport à l'axe de la solidification et/ou nécessitant le respect de deux orientations cristallines, on peut citer comme exemple caractéristique les distributeurs haute pression DHP. Ils sont fabriqués suivant le procédé de fonderie à cire perdue en utilisant des germes starter à la base de la grappe. L'invention propose d'utiliser des artifices accolés, autrement dits germes bruts, au produit qui deviendront à leur tour des germes starter monocristallins.

On décrit ci-après le procédé de l'invention en l'appliquant à la fabrication d'un distributeur haute pression DHP.

En référence à la figure 2, on décrit un mode de fabrication de germes brut par voie d'injection de cire monobloc.

La première étape de la fabrication des germes bruts simultanément à des distributeurs haute pression DHP consiste en une injection monobloc de cire, dans un moule métallique, d'un modèle 10 composé d'un ensemble d'éléments :
Un premier élément 11 forme la pièce, ici le DHP. On reconnaît sur cette pièce de DHP les deux plateformes 11A entre lesquelles s'étend une pale 11B,
Un deuxième élément 13 figure le germe starter. On reconnaît sur cet élément un méplat 13A grâce auquel on peut ultérieurement procéder à l'indexation du germe starter par rapport à la cavité figurant la pièce.
Deux troisièmes éléments 14 qui forment l'amenée de coulée de métal en fusion.
Un quatrième élément 15 forme une amenée de grain entre le germe starter et la pièce,

On observe sur ce modèle monobloc 10 que le modèle de la pièce 11 est disposé de telle façon que les platefonnes 11A soient disposées verticalement, selon l'axe primaire <001> qui est l'axe du genne starter. Le germe starter est lui-même de fonne cylindrique dont l'axe principal est l'axe primaire de solidification. La pale 11B est ainsi orientée selon un axe cristallographique transverse <010> ou <100>.

Les deux troisièmes éléments 14 sont conformés de manière à pouvoir y dégager deux gennes bruts 14A de même forme que le germe starter. Ils sont de forme cylindrique avec un méplat 14A'.

Les germes bruts après solidification du métal, parachèvement et contrôle, pourront à leur tour être utilisés comme starter. Après que l'on a obtenu plusieurs modèles cire monobloc, on assemble ces différents modèles pour former une grappe comprenant notamment les amenées de coulée et le godet qui recevra le métal lors de la coulée.

On fabrique donc autour du modèle 10 en cire une carapace céramique de façon connue, selon des opérations alternées de trempé dans une barbotine céramique suivi de l'application de couches de sables par immersion dans un lit fluidisé ou saupoudrage pluie. Après chaque trempé et application de sable céramique, on effectue un séchage intercouche. On répète plusieurs fois cet enchaînement d'opérations jusqu'à obtenir l'épaisseur voulue de céramique pour le moule carapace. Quand l'épaisseur de céramique est suffisante autour du modèle en cire on effectue le séchage final de la carapace ainsi obtenue.

On élimine ensuite la cire 10 du moule carapace puis on effectue la cuisson du moule. Ce dernier est alors prêt pour la coulée de l'alliage.

Le moule carapace est placé dans l'enceinte d'un four classique pour solidification dirigée. Le germe starter a été placé dans le logement cylindrique prévu à cet effet dans la base de la carapace céramique et qui est venu de l'élément 13 du modèle 10.

L'alliage vient, après la coulée, en contact avec le germe qui refond partiellement. La solidification est alors opérée par tirage ou toute autre technique connue. On obtient en fin de solidification une pièce DHP et des germes bruts monocristallins dans la carapace. La carapace est ensuite décochée et le barreau découpé aux dimensions requises et contrôlé afin de vérifier les orientations primaire et secondaire des germes obtenus.

On estime que l'orientation cristallographique des germes bruts est représentative de la pièce DHP. Le contrôle de l'orientation cristalline du DHP est ainsi évité. On peut ensuite utiliser les germes comme germes starter pour la fabrication de pièces monocristallines, par exemple des distributeurs. Les opérations de parachèvement : tronçonnage du germe starter, des amenées de grain, meulage, sablage sont menées en parallèle du contrôle radiocristallographique du germe permettant ainsi un gain de temps de la fabrication globale de la pièce DHP.

Conformément à une variante on peut fabriquer les germes bruts sans nécessiter une injection de cire monobloc ;

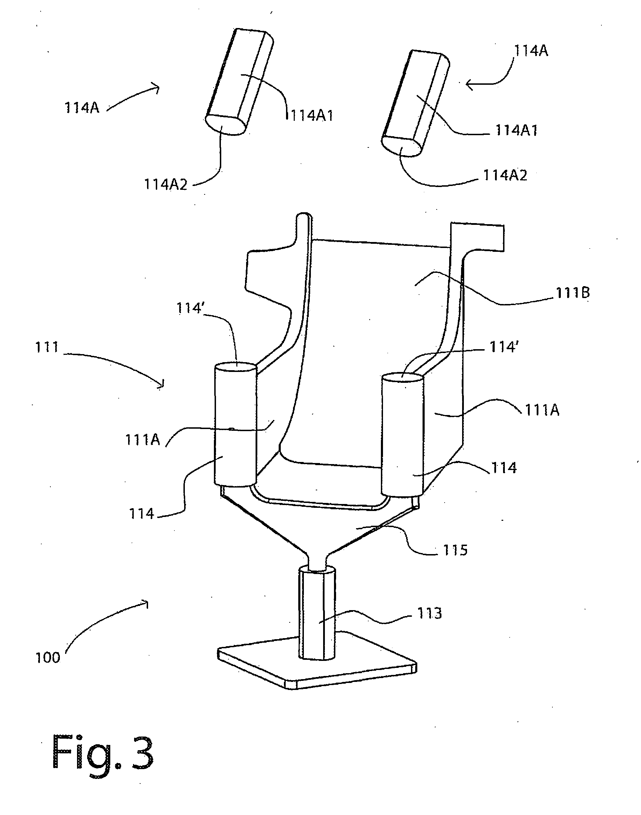

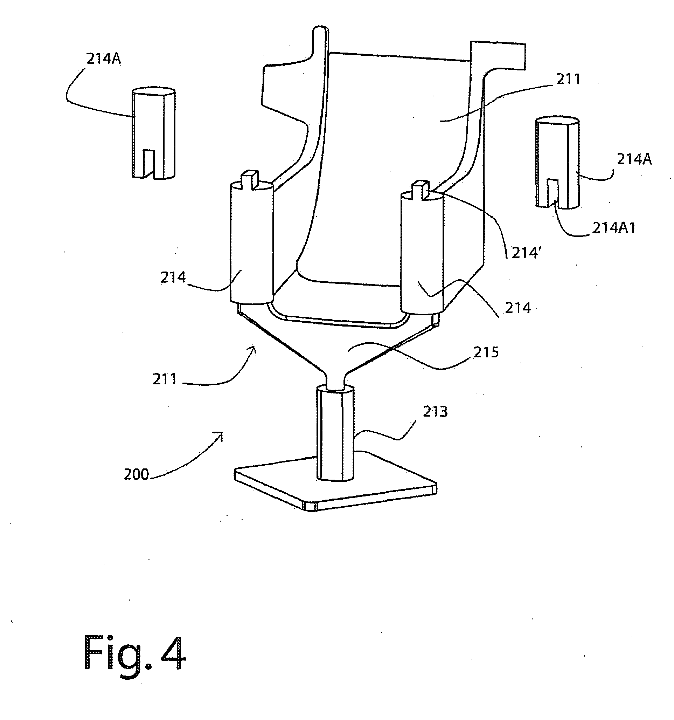

Cette deuxième voie utilisée pour la fabrication de germes sans injection du modèle cire monobloc est illustrée par les figures 3 et 4 où les références correspondantes de la figure 2 ont été augmentées de 100.

On retrouve le deuxième élément formant le germe starter 113, le quatrième élément formant l'amenée de grain 115, le modèle du DHP 111 avec les plateformes 111A et la pale 111B et le troisième élément pour les amenées de coulée de métal 114. Ces éléments 114 sont injectés monobloc avec les plateformes 111A. Les éléments formant les gennes bruts 114A ont été fabriqués séparément dans des moules d'injection, et sont amenés sur un outillage de positionnement par lequel ces éléments sont assemblés. Chaque élément formant germe brut 114A est positionné par rapport à la pièce, ici DHP, en étant indexé en rotation, ceci permet d'orienter le méplat 114A1 et par conséquent de respecter des orientations cristallines primaire et secondaire du germe brut. La face inférieure 114A2 des modèles de germe brut en cire est collée sur la face supérieure 114' du modèle cire de la portion formant amenée de coulée de métal dans la plateforme 111A de la pièce.

Une variante du mode opératoire pour l'indexation est illustré figure 4 sur laquelle les références correspondantes de la figure 3 sont les mêmes augmentées de 100. Le modèle cire du germe brut 214A est indexé sur le modèle cire 211 et plus particulièrement de la portion d'amenée 214 de coulée de métal de la pièce 200 par une liaison de type tenon et mortaise. Le modèle cire du germe brut 214A est doté d'une entaille 214A1 alors que le modèle cire de la pièce 200 est doté d'un tenon 214'.

Une fois assemblés, le modèle cire final comporte les mêmes éléments que le modèle monobloc de la figure 2.

Pour ces deux variantes, les étapes suivantes du procédé sont identiques à celles de la première solution qui décrivait l'obtention de germes bruts à partir d'un modèle cire injecté monobloc.

## Revendications

1. Procédé de fabrication d'au moins un germe monocristallin susceptible d'être utilisé comme germe starter dans la fabrication d'un distributeur haute pression de turbomachine, avec au moins une pale entre deux plateformes, monocristallin, par coulée de métal, comportant les étapes suivantes :
on réalise un modèle en cire (10 ; 100 ; 200) comprenant
un premier élément (11 ; 111 ; 211) formant modèle du distributeur,
un deuxième élément (13 ; 113 ; 213) formant modèle de germe starter comportant un méplat de localisation des orientations cristallines et au moins
un troisième élément (14 ; 114; 214) incorporant un modèle (14A ; 114A ; 214A) de germe brut avec un méplat de localisation des orientations cristallines,
on forme un moule carapace en céramique à partir dudit modèle en cire (10 ; 100 ; 200), et on incorpore un germe starter comportant ledit méplat de localisation des orientations cristallines dans le moule,
on coule un métal dans le moule et
on opère une solidification dirigée du métal dans le moule à partir du germe starter de manière que le germe brut obtenu ait la même structure cristallographique que la pièce et
on sépare le germe brut obtenu de la pièce pour une utilisation ultérieure comme germe starter, **caractérisé par le fait que** le modèle comprend deux troisièmes éléments (14 ; 114 ; 214) formant amenées de coulée de métal en fusion, chacun incorporant un élément formant modèle de germe brut (14A ; 114A ; 214A)).

2. Procédé selon la revendication 1 dont le modèle en cire (10 ; 100 ; 200) comprend un quatrième élément (15; 115 ; 215) formant amenée de grain entre le deuxième élément (13; 11.3 ; 213) et le premier élément (11 ; 111 ; 211).

3. Procédé selon la revendication 1 ou 2 selon lequel la pièce est orientée de façon que les pales soient disposées selon l'axe secondaire et les plateformes selon l'axe primaire.

4. Procédé selon l'une des revendications précédentes selon lequel le modèle en cire (10) est formé par injection dans un moule à cire ménageant l'ensemble desdits éléments.

5. Procédé selon la revendication 1 selon lequel le modèle (100) est formé par injection dans un moule à cire ménageant les premier (111) et deuxième (113) éléments, le troisième élément (114) comprenant un modèle de germe brut (114A ; 214A) réalisé séparément puis rapporté sur le modèle (100 ; 200).

6. Procédé selon la revendication précédente selon lequel un moyen d'indexation est ménagé entre le troisième élément (114, 214) et le modèle (100 ; 200).

7. Procédé selon la revendication précédente selon lequel le moyen d'indexation est constitué par une liaison (214' - 214A1) de type tenon et mortaise entre le modèle (200) et le troisième élément (214) formant modèle de germe brut.

8. Procédé selon la revendication 1 selon lequel le contrôle radiocristallographique de la pièce est effectué à partir du germe brut.

## Claims

1. Process for manufacturing at least one single-crystal seed that can be used as a starter seed in the manufacture of a single-crystal high-pressure turbine nozzle, with at least one vane between two platforms, by metal casting, comprising the following steps:
- a wax pattern (10; 100; 200) is produced, this comprising:
○ a first element (11; 111; 211) forming the pattern for the nozzle,
○ a second element (13; 113; 213) forming the pattern for the starter seed, including a flat face for localizing the crystalline orientations, and at least
○ a third element (14 ; 114 ; 214) incorporating a pattern (14A; 114A; 214A) for the crude seed with a flat face for localizing the crystalline orientations;
- a ceramic shell mold is formed from said wax pattern (10; 100; 200) and a starter seed, including said flat face for localizing the crystalline orientations, is incorporated into the mold;
- a metal is poured into the mold and
- the metal undergoes directional solidification in the mold from the starter seed, so that the crude seed obtained has the same crystallographic structure as the part; and
- the crude seed obtained is separated from the part for subsequent use as a starter seed, **characterised by** the fact that the pattern comprises two third elements (14; 114; 214) forming feeds of molten metal, each incorporating an element forming a crude seed pattern (14A; 114A; 214A)).

2. Process as claimed in claim 1, the wax pattern (10; 100; 200) for which includes a fourth element (15; 115; 215) forming a grain feed between the second element (13; 113; 213) and the first element (11; 111; 211).

3. Process as claimed in claim 1 or 2, wherein the part is oriented so that the vanes lie along the secondary axis and the platforms along the primary axis.

4. Process as claimed in one of the preceding claims, wherein the wax pattern (10) is formed by injection molding in a mold with wax, providing all of said elements.

5. Process as claimed in claim 1, wherein the pattern (100) is formed by injection molding in a mold with wax, providing the first (111) and second (113) elements, the third element (114) comprising a crude seed pattern (114A; 214A) produced separately and then attached to the pattern (100; 200) .

6. Process as claimed in the preceding claim, wherein an indexing means is provided between the third element (114, 214) and the pattern (100; 200) .

7. Process as claimed in the preceding claim, wherein the indexing means consists of a link (214' - 214A1) of the mortise-and-tenon type between the pattern (200) and the third element (214) forming the crude seed pattern.

8. Process as claimed in claim 1, wherein the part is checked by X-ray crystallography carried out on the crude seed.

## Patentansprüche

1. Verfahren zur Herstellung von zumindest einem Monokristallisationskeim, der fähig ist als Starterkeim in der Herstellung eines Turbomaschinen-Hochdruckverteilers verwendet zu werden, mit zumindest einem Blatt zwischen zwei Plattformen, monokristallin, durch Metallguss, das folgende Schritte umfasst:
das Realisieren eines Modells aus Wachs (10; 100; 200) umfassend
ein erstes Element (11; 111; 211) das das Modell des Verteilers bildet,
ein zweites Element (13; 113; 213) das das Modell des Starterkeims bildet, umfassend eine Abflachung zur Lokalisierung der Kristallorientierungen und zumindest
ein drittes Element (14; 114; 214) beinhaltend ein Rohkeimmodell (14A; 114A; 214A) mit einer Abflachung zur Lokalisierung der Kristallorientierungen,
das Formen einer Maskenform aus Keramik anhand des Modells aus Wachs (10; 100; 200), und Inkorporieren eines Starterkeims umfassend die Abflachung zur Lokalisierung der Kristallorientierungen in der Form,
das Gießen eines Metalls in die Form und
die derartige Ausführung einer gelenkten Erstarrung des Metalls in der Form anhand des Starterkeims, dass der erhaltene Rohkeim dieselbe kristallografische Struktur wie das Teil aufweist und
das Trennen des erhaltenen Rohkeims vom Teil für eine spätere Verwendung als Starterkeim, **dadurch gekennzeichnet, dass** das Modell zwei dritte Elemente (14; 114; 214) umfasst, die die Zufuhr von Schmelzmetallguss bilden, wobei jedes ein Element, das das Rohkeimmodell (14A; 114A; 214A) bildet, beinhaltet.

2. Verfahren nach Anspruch 1 dessen Modell aus Wachs (10; 100; 200) ein viertes Element (15; 115; 215) umfasst, das eine Kornzufuhr zwischen dem zweiten Element (13; 113; 213) und dem ersten Element (11; 111; 211) bildet.

3. Verfahren nach Anspruch 1 oder 2 nach dem das Teil derart orientiert ist, dass die Blätter nach der Sekundärachse angeordnet sind und die Plattformen nach der Primärachse.

4. Verfahren nach einem der vorhergehenden Ansprüche nach dem das Modell aus Wachs (10) durch Einspritzen in eine Wachsform geformt wird, die die Gesamtheit der Elemente ausspart.

5. Verfahren nach Anspruch 1 nach dem das Modell (100) durch Einspritzen in eine Wachsform geformt wird, die das erste (111) und das zweite (113) Element freilegt, wobei das dritte Element (114) ein Rohkeimmodell (114A; 214A) umfasst, das getrennt realisiert wird und auf das Modell (100; 200) angefügt wird.

6. Verfahren nach dem vorhergehenden Anspruch nach dem ein Indexierungsmittel zwischen dem dritten Element (114, 214) und dem Modell (100; 200) ausgespart ist.

7. Verfahren nach vorhergehenden Anspruch nach dem das Indexierungsmittel durch eine verzapfungsartige Verbindung (214' - 214A1) zwischen dem Modell (200) und dem dritten Element (214), das das Rohkeimmodell bildet, hergestellt wird.

8. Verfahren nach Anspruch 1 nach dem die radiokristallografische Steuerung des Teils anhand des Rohkeims erfolgt.
